(19) Europäisches Patentamt
European Patent Office
Office européen des brevets

(11) **EP 4 723 171 A1**

(12) **EUROPEAN PATENT APPLICATION**

(43) Date of publication:
**08.04.2026 Bulletin 2026/15**

(21) Application number: **24204472.5**

(22) Date of filing: **03.10.2024**

(51) International Patent Classification (IPC):
**H01L 23/495** *(2006.01)* **H01L 23/473** *(2006.01)*
**H05K 7/20** *(2006.01)* **H05K 1/02** *(2006.01)*
**H01L 23/48** *(2006.01)* *H01L 23/31* *(2006.01)*

(52) Cooperative Patent Classification (CPC):
**H10W 40/47; H05K 1/0209; H10W 70/461;**
**H10W 72/30; H10W 72/90;** H10W 46/301;
H10W 46/607; H10W 72/01961; H10W 74/111

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicants:
• **Nederlandse Organisatie voor toegepast-**
**natuurwetenschappelijk onderzoek TNO**
**2595 DA 's-Gravenhage (NL)**

• **Technische Universiteit Delft**
**2628 CN Delft (NL)**

(72) Inventors:
• **MARTIN, Henry Antony**
**2628 CN Delft (NL)**
• **SMITS, Edsger Constant Piter**
**2595 DA's-Gravenhage (NL)**

(74) Representative: **V.O.**
**P.O. Box 87930**
**2508 DH Den Haag (NL)**

(54) **PACKAGED ELECTRONIC DEVICE, SYSTEM COMPRISING A PACKAGED ELECTRONIC DEVICE AND METHOD OF MANUFACTURING A PACKAGED ELECTRONIC DEVICE**

(57) A packaged electronic device (1) is provided that comprises:
a lead frame (10) comprising a fluid channel (11);
an electronic device (20) mounted on a surface of the lead frame a package (30) enclosing the lead frame and the electronic device comprising openings (12a, 12b) giving access to the fluid channel and terminals (40a, 40b) for providing electric contacts to the electronic device.

Fig. 1A

EP 4 723 171 A1

**Description**

BACKGROUND

The present invention pertains to a packaged electronic device.

The present invention further pertains to a system comprising a packaged electronic device.

The present invention still further pertains to a method of manufacturing a packaged electronic device.

The increasing demand for high-power, high-frequency electronic devices has exacerbated thermal management challenges. Semiconductor devices operating in harsh environments, such as power inverters in Electric Vehicles (EVs), experience temperature fluctuations exceeding 110 °C and heat fluxes ranging from ~100W/cm2 to ~1000W/cm2. Overheating not only reduces device lifespan but also compromises system efficiency and performance.

In the automotive sector, high-power electronic devices, such as traction inverters and rectifiers predominantly rely on single-phase liquid-cooled heat sinks. While liquid-cooled heat sinks are widely used in automotive inverters, they are bulky and require substantial coolant volumes. For instance, the inverter module in the 2015 Tesla Model-S weighs 5.8 kilograms and requires 6.4 liters of coolant.

US2009294954 discloses another approach, which provides three dimensional integrated circuits with microfluidic interconnects. A microfluidic integrated circuit system disclosed comprises a plurality of semiconductor die wafers that each have a top and bottom exterior surface and that can form a stack of die wafers. The die wafers can comprise one or more channels formed through the die wafers. The channels generally extend between top and bottom exterior surfaces of the semiconductor die wafers. A plurality of micro-pipes is disposed between adjacent semiconductor die wafers in the stack that enable the channels to be in fluid communication with each other. A barrier layer can be disposed within at least one of the channels and the micro-pipes to prevent a coolant flowing through the at least one of the channels and the micro-pipes from leeching into the channels and micro-pipes.

While integrating microfluidics at the chip level offers notable advantages, it introduces significant complexity in fabrication. Design of such three dimensional integrated circuits is in particular complicated as the arrangement of the microfluidic channels and micro-pipes cannot be provided independently of the arrangement of electronic elements like interconnections and circuitry. Therewith other design choices of the electronic elements may necessitate also other design choices of the arrangement of the microfluidic channels and micro-pipes.

Accordingly, there is a need to provide more universally applicable measures for cooling high power devices having a modest weight and cooling volume requirements.

SUMMARY

According to a first aspect of the present disclosure an improved packaged electronic device is provided. The improved packaged electronic device comprises a lead frame with a fluid channel, an electronic device mounted on a surface of the lead frame, and a package enclosing the lead frame and the electronic device. The package comprises openings that give access to the fluid channel and terminals for providing electric contacts to the electronic device.

The arrangement of the electronic device mounted on the surface of the lead frame provides for an efficient conduction of heat from the electronic device via the lead frame to the fluid in the cooling channel. The arrangement of the lead frame within the package renders it possible to perform cooling with a small amount of cooling liquid because the heat is collected close to the location where it is generated in sharp contrast to the case where cooling is provided by a heat sink outside the package. In the latter case the heat developed by the electronic circuit is spatially distributed and has to be collected from a larger area. That would necessitate a more bulky heat exchanger and a larger amount of cooling fluid. The improved packaged electronic device, wherein the electronic device is mounted on the surface of the lead frame is also universally applicable. The electronic device and the lead frame can be provided independent from each other. When designing another improved packaged electronic device comprising another electronic device or updated version of the electronic device a new design of the lead frame is not necessary as long as the electronic device does not exceed the cooling capacity of the lead frame.

The electronic device is for example an integrated circuit, for example for high power applications as mentioned above, like such as traction inverters and rectifiers.

In an embodiment of the improved packaged electronic device, the lead frame is an assembly comprising a bottom plate, a central plate and a top plate, wherein the central plate is patterned to form the fluid channel. The assembly can be manufactured in an efficient manner by punching and blanking.

In one example the fluid channel extends in a meandering manner through the lead frame. I.e. it has a serpentine shape. The serpentine shape of the fluid channel renders possible a uniform flow of the fluid within the lead frame within the area where the electronic device is arranged on the surface of the lead frame. The serpentine pattern of the fluid channel can be formed in a single subtractive manufacturing step by punching.

In an example, the lead frame has extension portions for coupling ends of the fluid channel to the openings. In an example the fluid channel is punched in the central plate so as to extend within mutually opposite extension and one of the bottom plate and the top plate is provided with an opening in each corresponding extension. Therewith the fluid channel is accessible by the openings in the top plate. In another example the openings to the fluid channel are provided in the bottom plate. In again another example one opening to the fluid channel is provided in the bottom plate and another one in the top plate.

Also the lead frame may have further extension portions having at their free ends a respective opening through the lead frame distinct from the fluid channel. These openings protruding through each of the plates can serve for alignment and/or attachment of the lead frame.

In an embodiment the electronic device is fixed to the surface of the lead frame with a metal or with a material comprising a metal component. The metal, e.g. a solder, or the metal component, e.g. metal particles in a sintered paste provide for an good heat transfer from the electronic device to the lead frame.

In an embodiment the lead frame soldered on a printed circuit board, PCB, comprised in the package. Soldering the lead frame to the PCB avoids usage of additional mounting elements and instead avails the metal leads present on the PCB.

According to a further aspect of the present disclosure an electronic system is provided that comprises in addition to at least one packaged electronic device as described above a power supply and cooling fluid circuit. The power supply serves for supplying an electric power to the electronic device. The cooling fluid circuit serves for circulating a cooling fluid through the fluid channel of the lead frame and may comprise for example a fluid pump and a heat exchanger. The electronic system may be provided with one or more further packaged electronic devices. These may share the power supply or have their proper power supply. Likewise they may share the cooling fluid circuit or have their proper cooling fluid circuit. In addition the electronic system may comprise other devices, for example electronic or optical devices, which do not require cooling.

According to a still further aspect of the present disclosure an improved method of packaging an electronic device is provided. The improved method comprises:

> providing a printed circuit board, PCB;
> providing a lead frame comprising a fluid channel;
> fixing the lead frame to the PCB;
> fixing the electronic device to a surface of the lead frame;
> wirebonding the electric contacts of the electronic device to electric terminal connections provided on the PCB;
> encapsulating the PCB provided with the lead frame and the electronic device, therewith providing openings giving access to the fluid channel and providing terminals serving as electric contacts to the electronic device.

BRIEF DESCRIPTION OF THE DRAWINGS

These and other aspects are described in more detail with reference to the drawing. Therein:

> FIG. 1A, 1B schematically show embodiments of an improved packaged electronic device;
> FIG. 2 schematically shows a system that comprises an improved packaged electronic device;
> FIG. 3 shows a cross-sectional view according to III-III in FIG. 1B;
> FIG. 4A, 4B show an exemplary component of the improved packaged electronic device;
> FIG. 5A, 5B and 5C show alternative examples of the component and FIG. 5BA, 5BB, 5BC and 5BD shows details of the alternative of FIG. 5B respectively;
> FIG. 6 schematically shows an improved method of packaging an electronic device;
> FIG. 7 shows a Thermal Test Chip (TTC) as used for testing the improved packaged electronic device;
> FIG. 8 shows a possible manufacturing step;
> FIG. 9 shows experimental setup for testing the improved packaged electronic device;
> FIG. 10 schematically shows three test products for evaluating the improved packaged electronic device and comparing its performance with that of standard implementations;
> FIG. 11 shows temperature measurements over time performed with the experimental setup of FIG. 9;
> FIG. 12 shows further measurement results;
> FIG. 13 shows a table wherein a summary of measurement results is presented;
> FIG. 14 shows a one-dimensional heat transfer model;
> FIG. 15 shows a comparison of a thermal resistance for various cases.

DETAILED DESCRIPTION OF EMBODIMENTS

Like reference symbols in the various drawings indicate like elements unless otherwise indicated.

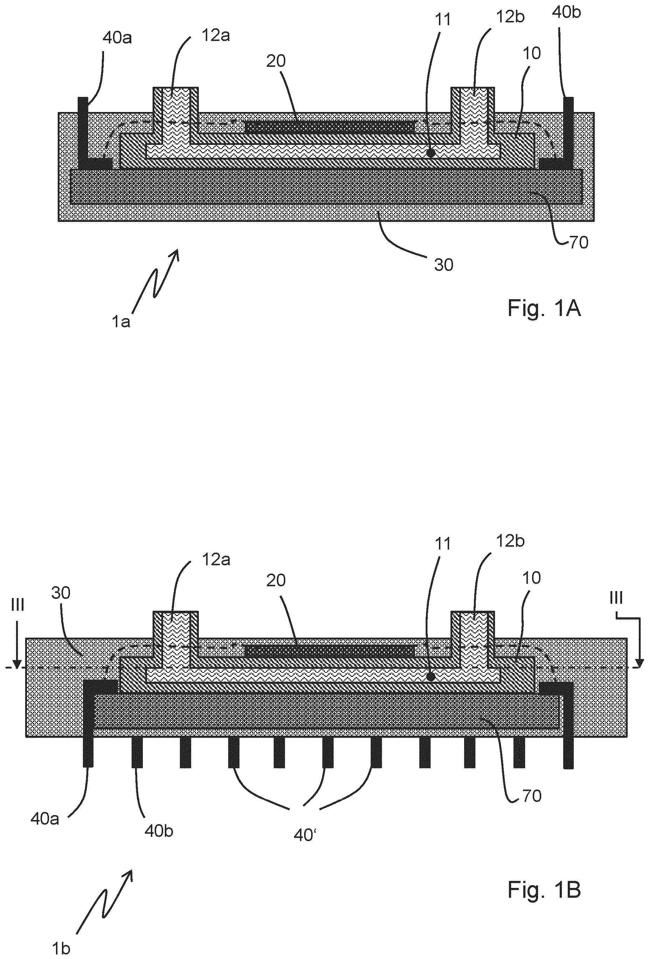

FIG. 1A schematically shows an embodiment of an improved packaged electronic device 1a that comprises a package 30 enclosing an electronic device 20 mounted on a surface of a lead frame 10, comprising a fluid channel 11. The package 30 has terminals 40a, 40b for providing electric contacts to the electronic device 20 and comprises openings 12a, 12b that give access to the fluid channel 11. The packaged electronic device 1a in the example shown in FIG. 1A has the openings 12a, 12b and the terminals 40a, 40b at the same main surface of the package. Whereas only two terminals are shown, in practice the a larger number of terminals may be provided, e.g. some tens or even hundreds of terminals.

FIG. 1B schematically shows another embodiment of an improved packaged electronic device 1b which differs from the device 1a in that the terminals 40a, 40b, 40' for providing electric contacts to the electronic device 20 and the openings 12a, 12b that give access to the fluid channel 11 are arranged on mutually opposite main surfaces of the packages. Also other configurations may be contemplated wherein the terminals and/or the openings are provided at a lateral side of the package.

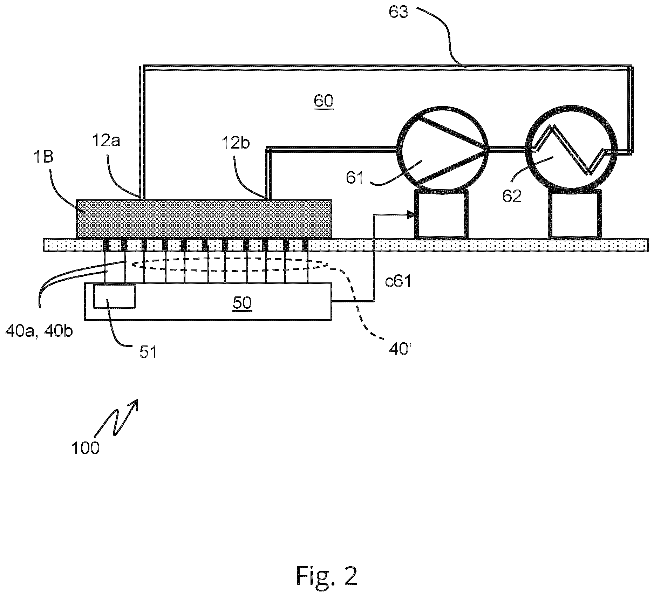

FIG. 2 schematically shows a system 100 that comprises an improved packaged electronic device 1b as shown in FIG. 1B. Another example may comprise an improved packaged electronic device with another configuration as discussed above. The system further comprises a power supply 51 for supplying an electric power to the electronic device and a cooling fluid circuit 60 for circulating a cooling fluid through the fluid channel 11 of the lead frame 10, see FIG. 1B). The power supply serves for supplying an electric power to the electronic device. In the embodiment shown, the cooling fluid circuit 60 comprises a fluid pump 61 and a heat exchanger 62 that are coupled with the fluid channel 11 by a fluid tube 63. The power supply 51 coupled to terminals 40a, 40b is part of a control circuit 50, which is also coupled to further terminals 40' of the packaged electronic device 1B. For illustrative purposes FIG. 2 shows a system 100 with only a limited number of components. In other embodiments system 100 may be provided with one or more further packaged electronic devices. These may share the power supply 51 and controller 50 or have their own power supply. Likewise, they may share the cooling fluid circuit 60 or have their own cooling fluid circuit. In addition the electronic system may comprise other devices, for example electronic or optical devices, which do not require cooling.

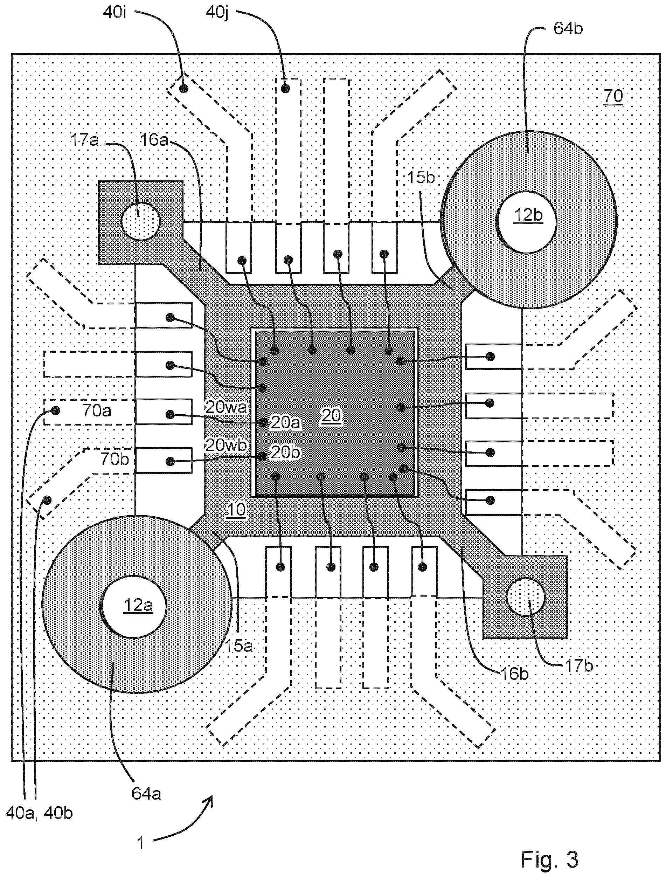

FIG. 3 shows a cross-sectional view according to III-III of the packaged electronic device 1a in FIG. 1B. As shown therein the terminals 40a, 40b are electrically connected by electric circuit lines 70a, 70b of the PCB 70 and wires 20wa, 20wb to contact pads 20a, 20b of the electronic device 20, therewith providing electric contacts to the electronic device. Other contact pads of the electronic device are similarly connected to terminals. In some embodiments multiple contact pads are connected to a shared terminal, or a plurality of terminals may be connected to a same contact pad. In the embodiment shown in FIG. 3, the lead frame 10 has extension portions 15a, 15b for coupling ends of the fluid channel 11 to the openings 12a, 12b. Ferrules 64a, 64b are provided around the openings 12a, 12b at free ends of the extension portions to facilitate coupling of a fluid tube for circulating the fluid. Due to the fact that the lead frame 10 has these extension portions, it is avoided that the fluid couplings unduly restrict a space for electrical connections to the electronic device 20. Therewith the electric circuit lines 70a, 70b, ... can have their ends close to the contact pads 20a, 20b, .. of the electronic device 20 so that the wires 20wa, 20wb, .. can be short. In the embodiment shown in FIG. 3 the lead frame 10 has further extension portions 16a, 16b having at their free ends a respective opening 17a, 17b through the lead frame distinct from the fluid channel. These further extension portions 16a, 16b facilitate alignment of the lead frame 10. Also the further extension portions 16a, 16b facilitate mounting the lead frame 10 on the PCB 70, for example, by a solder connection to metal connection portions provided on the PCB 70. In turn, the electronic device 20 may be fixed to the surface of the lead frame 10 with a metallic interconnect material. Therewith a heat transport from the electronic device 20 to the lead frame 10 is promoted.

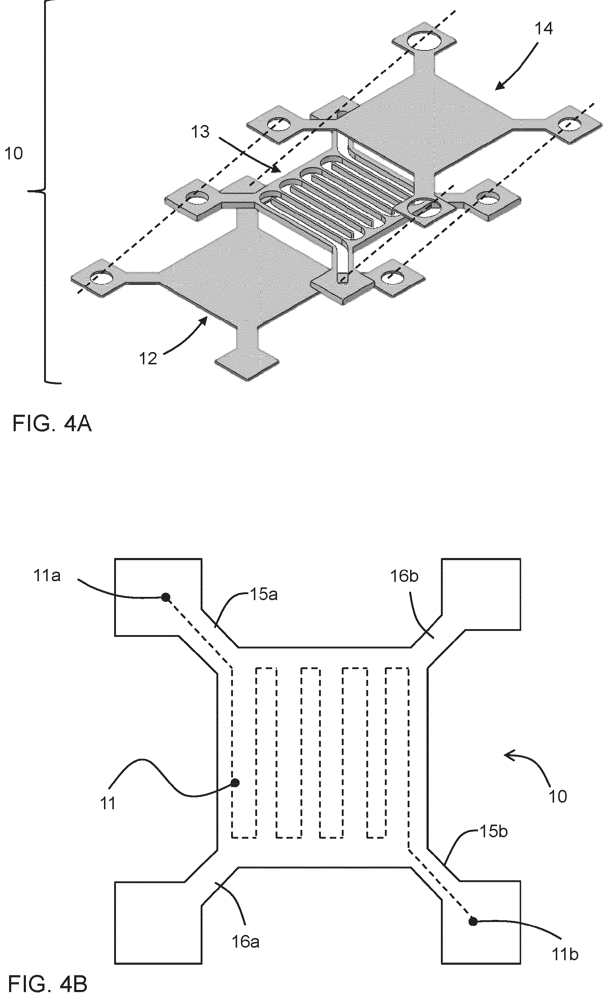

In an embodiment as shown in FIG. 4A the lead frame 10 is provided as an assembly that comprises a bottom plate 12, a central plate 13 and a top plate 14, wherein the central plate is patterned to form the fluid channel 11. The plates may be assembled for example with a solder or an adhesive. Good results were obtained with a metal filled adhesives, for example an Ag-filled epoxy adhesive, which has excellent thermal conduction properties. FIG. 4B also schematically shows a top view of the assembly 10. As shown in FIG. 4A, 4B the fluid channel 11 extends in a meandering manner through the lead frame 10. The serpentine configuration promotes turbulence and therewith improves transport of heat from the material of the lead frame 10 to the fluid in the fluid channel 11.

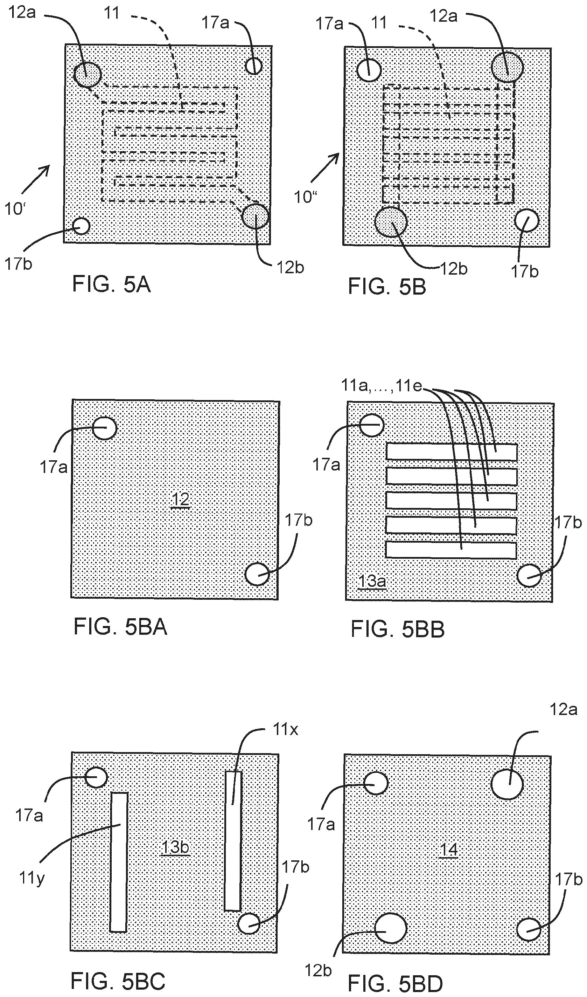

FIG. 5A and 5B show alternative examples of a lead frame 10' and 10" respectively. The lead frame 10' of FIG. 5A differs from the lead frame 10 of FIG. 4A, 4B in that it has no extension portions, but is otherwise the same. The lead frame 10" of FIG. 5B differs from that of FIG. 5A in that it is assembled of four patterned metal plates 12, 13a, 13b and 14, as shown in FIG. 5BA, 5BB, 5BC and 5BD respectively. The central plate 13a defines a set of parallel channels 11a,..., 11e in a first planar direction. The central plate 13b defines two parallel channels 11x, 11y in a second planar direction different from the first planar direction. When assembled, for example using a metal filled adhesive, a fluid channel 11 is formed, that extends from one opening 12a, via the vertical channel 11x, and the parallel channels 11a,..., 11e, and the vertical channel 11y to the other opening 12b.

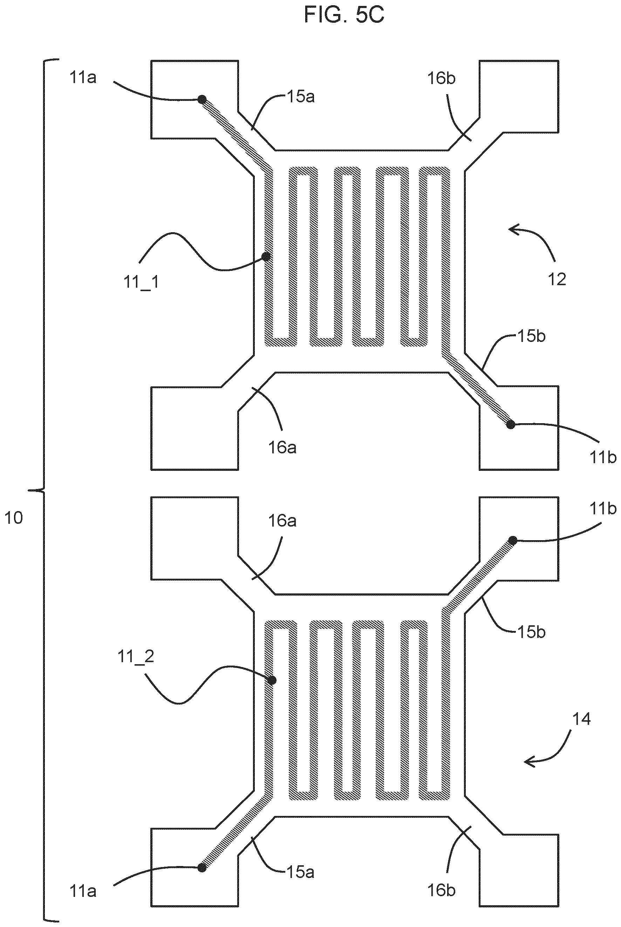

A further example is shown in FIG. 5C, wherein the three-layered assembly of the lead frame 10 of FIG. 4A, 4B is replaced with a two-layered assembly. Therein each of the two layers 12, 14 is etched to a part of its depth to form a respective groove 11_1, 11_2, and the two layers are bonded to each other at their etched sides, so that the grooves 11_1, 11_2 face each other and together form the fluid channel in the assembly formed by layers 12, 14.

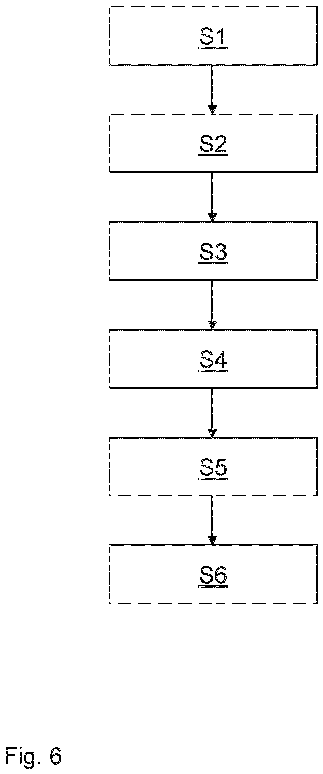

FIG. 6 schematically shows an improved method of packaging an electronic device 20. In step S1 thereof a printed circuit board, PCB is provided. The PCB typically has electric circuit lines, e.g. 70a, 70b, .. for providing electrical connections as shown for example in FIG. 3. In step S2 a lead frame 10 comprising a fluid channel 11 is provided, for example by assembling the lead frame from a set of patterned plates as described with reference to FIG. 4A, 4B. In step S3 the lead frame 10 is fixed to the PCB 70. To that end the PCB may have mounting pads. Therewith the lead frame can be fixed in this step S3 by soldering. In step S4 the electronic device 20 is fixed to a surface of the lead frame 10. As noted above, it is favorable to use a metal filled adhesive for this purpose. In step S5 the electric contacts of the electronic device 20 to electric terminal connections provided on the PCB 70. In step S6 the PCB 70 provided with the lead frame 10 and the electronic device 20 is then encapsulated. The encapsulation provides for openings 12a, 12b that give access to the fluid channel and for terminals 40a, 40b that serve as electric contacts to the electronic device.

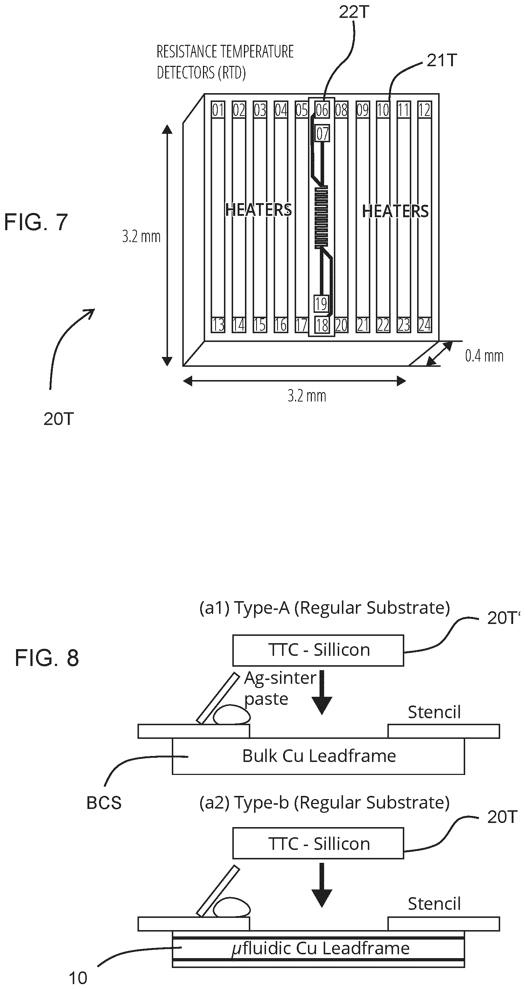

FIG. 7 shows a Thermal Test Chip (TTC) 20T provided as an electronic device for testing in an improved packaged electronic device. The Thermal Test Chips (TTC), is a specialized device fabricated using the same process technology as semiconductor devices. The TTC as shown in FIG. 7 is a commercially available Silicon-based lateral device with integrated heating 21T and temperature-sensing elements 22T. Each heating element 21T has a resistance of 165 $\Omega$ @ 25 °C, and the Resistance-based Temperature Detector (RTD) of the TTC features a 4-point probe configuration with 3.7kS2 @ 25 °C. The temperature sensitivity of the TTC was determined through a two-step calibration process. For RTD resistance calibration below 150 °C, the TTCs were measured inside an oven at different ambient temperatures. For temperatures above 150 °C, an input power of 3W was applied to the heaters by connecting all heating elements in parallel, and the change in RTD resistance was measured while simultaneously measuring the device junction temperature using an Infra-Red (IR) camera. The measured RTD resistance and the junction temperature were in a steady state. A linear relationship was established by fitting both calibration measurements, resulting in a sensitivity of around 7$\Omega$/°C.

For IR measurements, a TTC as described above was sintered on a bulk copper substrate, which was further soldered onto a PCB and wire bonded. The backside of the TTC (Silicon substrate) was metalized with TiPtAu (100/100/100nm) to promote adhesion to the die-attach material.

A lead frame 10 with a serpentine fluid channel 11 as shown in FIG. 4A, 4B was provided. It is conjectured that the serpentine configuration induces a localized turbulence, which enhances heat dissipation as compared to a configuration with straight channels. The microchannel dimensions were standardized at a width of 0.3mm and a height of 0.5mm, with a total channel length of -50mm between the inlet 12a and outlet 12b.

The lead frame comprises three laser-cut copper layers: a 0.1mm top plate 14, a 0.3mm microchannel middle layer 13, and a 0.1mm bottom plate 12. These layers were assembled using conductive Ag-filled epoxy adhesive. The inlet 12a and outlet 12b were placed along the diagonals 15a, 15b of the lead frame 10, with additional alignment markers 17a, 17b positioned along the counter-diagonal 16a, 16b for assembly.

Ag-sintering was selected as the die-attach material for attaching a first TTC 20T to the lead frame 10. For reference another TTC 20T' was fixed to a bulk copper substrate BCS. To that end the Ag-sinter paste, that has a superior thermal conductivity compared to traditional solder alloys, was applied to the lead frame's 10 die pad using stencil printing as shown in FIG. 8. The upper and the lower part of FIG. 8 respectively show this for the bulk copper substrate BCS and the lead frame 10.

The TTC's 20T, 20T' were then positioned on the wet paste and subsequently cured in a nitrogen atmosphere within a hot plate oven. The Ag-sintering profile comprises a linear increase in temperature from 30 °C to 90 °C in about 12 minutes, maintain the temperature stable during about 8-10 minutes, linearly increasing the temperature to 250 °C in a time interval of about 30 minutes, maintaining the temperature stable at 250 °C during about 45 minutes and linearly cooling down in about 75 minutes.

Following die bonding, the packages were soldered to a printed circuit board (PCB) and wire bonded. To ensure uniform heating across the device, all heating elements on the TTC 20T, 20T' were connected in parallel. For microfluidic packages, inlet and outlet ferrules 64a, 64b were secured using an adhesive. Finally, both package types were encapsulated with DAM and Fill encapsulants to provide environmental protection.

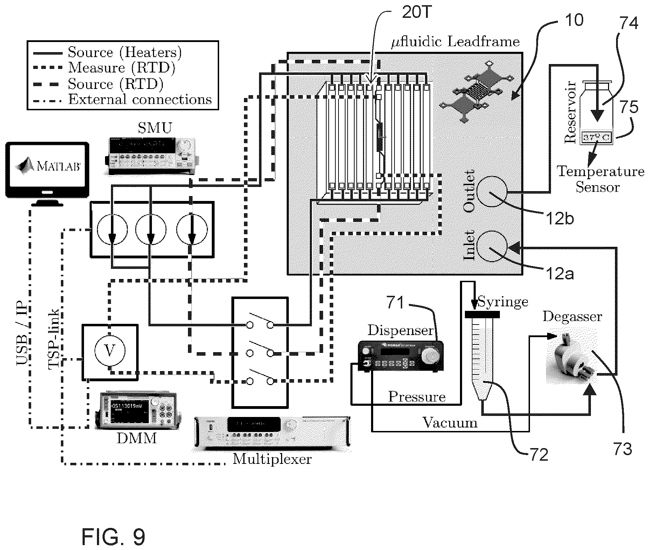

To assess the performance of the improved packaged electronic device 1 in comparison to the conventionally packaged electronic device a dedicated experimental setup was developed, as illustrated schematically in FIG. 9.

As shown therein the device to be tested was electrically connected to a measurement equipment via a multiplexer. The input currents for the heaters were sourced using a parallelly connected Source Measurement Unit (SMU) with compliance of 40V up to 2A continuous current. The change in RTD resistance was measured using a Digital MultiMeter (DMM), which has a resolution of 1$\mu$V for measurements up to 10V and an accuracy of $\pm$0.1mV. The SMU, DMM, and Multiplexer were synchronized through a Trigger Synchronization and Communication (TSP) protocol, and the measurement sequence was programmed using a user-defined MATLAB program.

An open-loop microfluidic system was implemented to evaluate the cooling performance. A pressure dispenser 71 with a maximum pressure of 675kPa was connected to a 10ml syringe 72 carrying demineralized water as the coolant. Inlet coolant temperature was recorded, and the fluid was subsequently passed through a 300$\mu$l degasser 73 to eliminate air bubbles. The degasser removes air bubbles from the fluid, preventing blockage and localized explosions. The fluid outlet 12b was collected in a reservoir 74, and the outlet temperature was measured with a thermocouple 75 at one-millisecond intervals. In this study, the pressure drop across the microfluidic system was not measured.

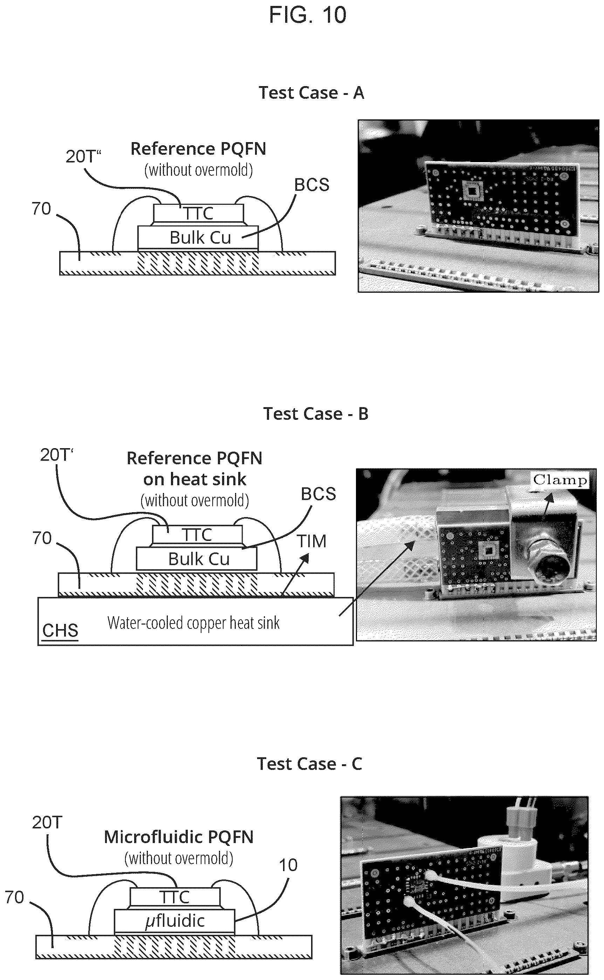

As previously outlined, two distinct package configurations were fabricated: standard lead frame packages and microfluidic lead frame 10 packages. To facilitate comparative analysis, three experimental test cases A, B, C were defined as shown in FIG. 10. Therein the column on the left side and the column on the right side respectively show a cross-section and a picture of each test case. Therein:

Test Case - A: Reference PΓaFN package with a standard leadframe BCS and natural convection cooling,

Test Case - B: Reference PΓaFN package with a standard leadframe BCS mounted on a water-cooled (demineralized) copper heat sink CHS using thermal interface material (TIM), and

Test Case - C: PΓaFN package with a water-cooled (demineralized) microfluidic lead frame 10.

Considering the epoxy encapsulant's glass transition temperature below 180 °C and the target maximum test temperature approaching the PCB solder reflow temperature (-300 °C), overmolding was excluded from the experimental protocol.

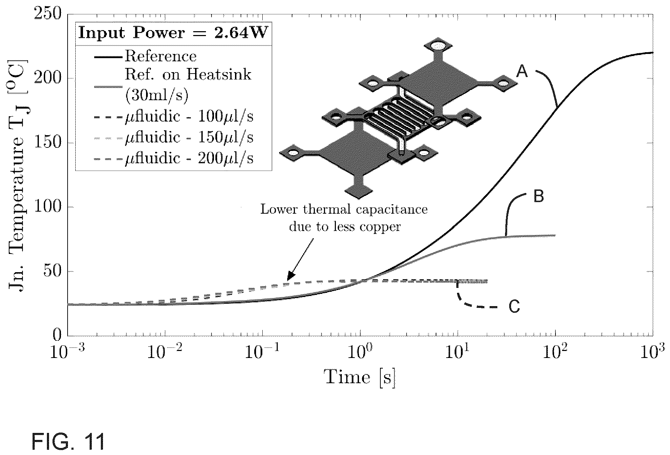

To assess package performance, the junction temperature of the test chip 20T, 20T', 20" was monitored until thermal equilibrium (steady state) was achieved for each test case. A constant power input of 2.64 W was applied across ten parallelly connected heaters, resulting in a power density of $25.78 W/cm^2$. Temperature variations over time are presented in FIG. 11, wherein the temperature curves A, B, C are shown for each of the test cases A, B, C respectively. The following was observed:

Test Case - A: The reference PΓaFN package with a standard lead frame under ambient conditions reached a steady-state junction temperature of 220 °C over 1000 seconds.

Test Case - B: The reference PΓaFN package mounted on a water-cooled heat sink attained a steady state junction temperature of 78 °C in 100 seconds. A constant flow rate of 30ml/s was maintained in the water-cooled copper heat sink CHS.

Test Case - C: The PΓaFN package with the microfluidic lead frame 10 achieved a steady-state junction temperature of 43 °C in less than 20 seconds. The device was subjected to three different flow rates: $100\mu l/s$, $150\mu l/s$, and $200\mu l/s$ (see FIG. 11). As the thermal capacitance of the microfluidic lead frame 10 is lower than the standard massive lead frames BCS, the temperature of the TTC mounted on the microfluidic package stabilizes faster. Minimal junction temperature variations ($\pm 0.5$ °C) were observed for the three different flow rates for an applied power of 2.64W, likely due to insufficient heating.

The results depicted in FIG. 11 demonstrate the advantages of the improved packaged electronic device, wherein the lead frame 10 on which the electronic device is mounted inside the encapsulation has a fluid channel 11.

Additional experiments were performed as specified below.

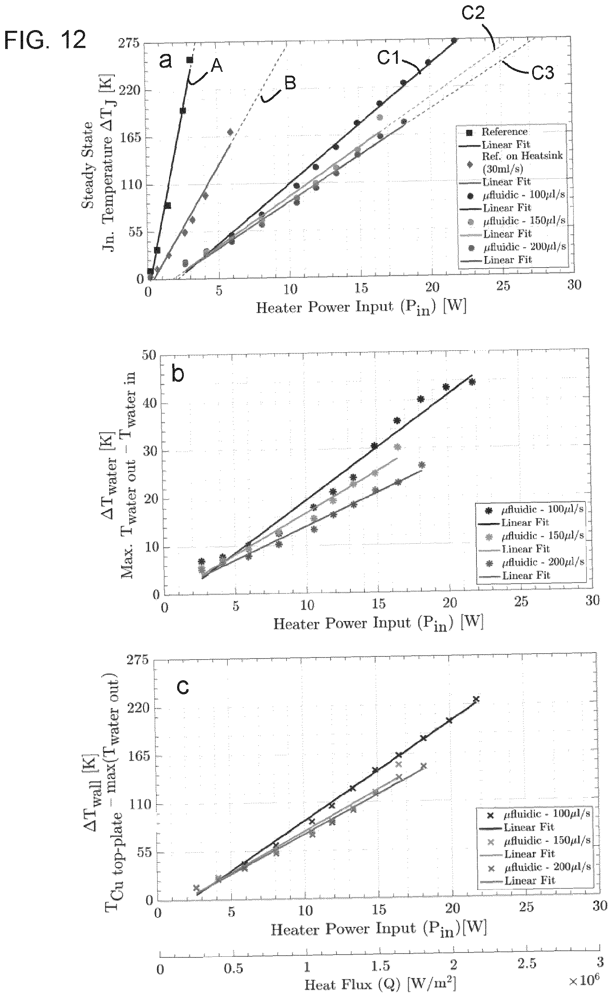

The experimental procedure was replicated using varying power inputs to the heating elements of the TTC 20T. The resulting steady-state junction temperature changes are presented in FIG. 12(a). As previously noted, the maximum junction temperature was constrained to the solder reflow temperature of 300 °C, limiting a maximum $\Delta T$ of 275 °C in FIG. 12(a). Linear regression analysis was performed on the measured temperature changes as a function of input power, yielding the following observations:

Test Case - A: The reference PΓaFN with ambient cooling resulted in a $\Delta T$ of 275 °C for power inputs less than 4W (See curve A in FIG. 12(a).

Test Case - B: The reference PΓaFN with a water-cooled heat sink CHS reached a $\Delta T$ of 170 °C at 5.9W input power. A maximum $\Delta T$ of 275 °C can be reached at 10 W, which indicates a three-fold increase in power input over Test Case - A. (See curve B in FIG. 12(a)

Test Case - C: The microfluidic package varies performance based on flow rate, with significant differences apparent at higher operating temperatures.

At a flow rate $100\mu l/s$, a $\Delta T$ of 275 °C (See curve C1) was achieved at a power input of -22W, marking a six-fold increase compared to the reference and a two-fold improvement over the heat sink. At a flow rate of $150\mu l/s$ and $200\mu l/s$, a $\Delta T$ of ~275 °C corresponds to power inputs of ~26W and -27.5W, respectively (See curves C2, C3).

The maximum power input for each test case at a $\Delta T$ of 275 °C is summarized in table 1. To evaluate the heat dissipation capabilities of the microfluidic packages, the system's total thermal resistance $R_{total}$ was analyzed which is a summation of caloric thermal resistance $R_{caloric}$, convective thermal resistance $R_{conv}$, and conductive thermal resistance $R_{cond}$ (see equation 1).

$$R_{total} = R_{caloric} + R_{conv} + R_{cond} \qquad (1)$$

The total junction-to-ambient thermal resistance $R_{total}$ can be determined using equation 2, which corresponds to the slope of the linear line shown in FIG. 12a.

$$R_{total} = \frac{\Delta T_J}{\Delta P_{in}} \qquad (2)$$

To quantify the caloric thermal resistance $R_{caloric}$ of the water, the change in water temperature ($\Delta T_{water}$) was determined by subtracting the inlet temperature from the maximum outlet temperature for various heater power inputs. The results are shown in FIG 12(b). It is important to note that while the inlet water temperature is in a steady state, the outlet temperature exhibits a transient behavior, though the device junction reached a thermal equilibrium. Therefore, the maximum outlet temperature was considered. A linear relationship between $\Delta T_{water}$ and input power was observed with $R_{caloric}$ corresponding to the slope of the linear line, as expressed in equation 3.

$$R_{caloric} = \frac{\Delta T_{water}}{\Delta P_{in}} \qquad (3)$$

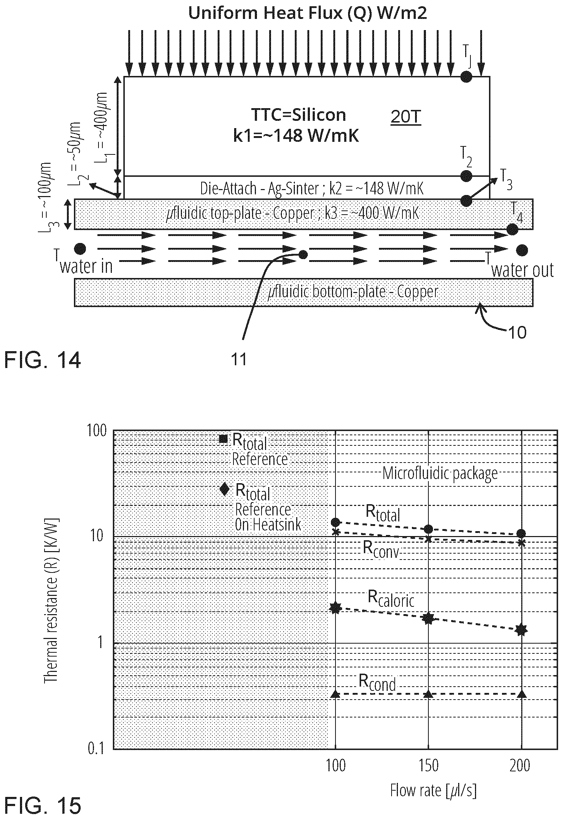

To determine the convective thermal resistance $R_{conv}$, the temperature difference across the wall $\Delta T_{wall}$ needs to be calculated. A one-dimensional heat transfer model was assumed between the TTC and the microfluidic top plate, as depicted in FIG. 14.

Neglecting ambient heat transfer and contact resistances, the heat transfer network can be represented by equation 4:

$$Q = \frac{-k_1(T_2 - T_J)}{L_1} = \frac{-k_2(T_3 - T_2)}{L_2} = \frac{-k_3(T_4 - T_3)}{L_3} \qquad (4)$$

The wall temperature difference, $\Delta T_{Wall}$, was calculated as the difference between the top copper plate temperature ($T_4$) and the maximum water outlet temperature (see FIG. 12 (c)). Subsequently, $R_{conv}$, was derived from equation 5, which represents the slope of the linear line in FIG. 12(c).

$$R_{conv} = \frac{\Delta T_{wall}}{\Delta P_{in}} \qquad (5)$$

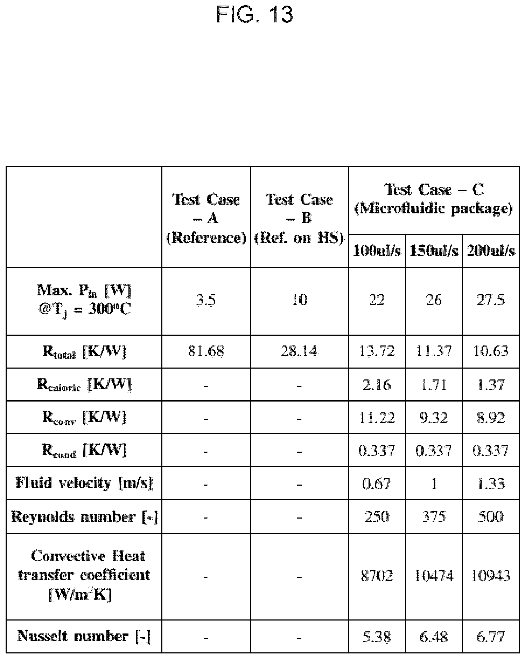

Given the calculated values of $R_{total}$, $R_{caloric}$, and $R_{conv}$, the conductive thermal resistance, $R_{cond}$, was determined using equation 1. The results are presented in figure 9 and summarized in the table in FIG. 13. The analysis revealed that the convective thermal resistance ($R_{conv}$) significantly contributes to the overall thermal resistance of the system $R_{total}$, while conductive resistance $R_{cond}$ remains relatively constant and less influential. Accordingly, the system can be best optimized by reducing $R_{conv}$ by modifying the fluid velocity, the fluid properties, or the active heat transfer area.

To further characterize the cooling performance, the fluid flow regime was analyzed. In typical single-phase microfluidic systems, laminar flow patterns are predominant. The dimensionless Reynolds number (Re), representing the ratio of inertial forces to viscous forces, was calculated to assess flow conditions. A Reynolds number exceeding 1800 to 2100 signifies the transition from laminar to turbulent flow. For flow through a pipe, the Reynolds number is determined from equation 6, where $\rho$ is the fluid density ($\rho_{water}$ = 1000 kg/m$^3$), v is the fluid velocity (m/s), DH is the hydraulic diameter of the microchannel (m), and $\mu$ is the dynamic viscosity of the fluid in ($\mu$water = 1 $\times$ 10$^{-3}$ kg/m s.

$$Re = \frac{\rho v D_H}{\mu} \qquad (6)$$

The fluid velocity was calculated by dividing the volumetric flow rate (in m$^3$/s) by the microchannel cross-sectional area. The hydraulic diameter of a rectangular channel is given by $D_H = \frac{4wh}{2(w+h)}$, where w is the channel width, and h is the channel height. Based on these calculations, the Reynolds numbers for different flow rates were found to be:

Re = 250 for a flow rate of 100$\mu$l/s,
Re = 375 for a flow rate of 150$\mu$l/s, and

Re = 500 for a flow rate of 200µl/s.

The fluid velocity and the obtained Reynolds numbers for all three flow rates are summarized in the table in FIG. 13. These values indicate that the flow remains laminar under all tested conditions. However, it is important to be aware that the serpentine channel design might induce localized turbulence within the fluidic substrate.

To evaluate heat transfer efficiency, the dimensionless Nusselt number was calculated using equation 7. The Nusselt number represents the ratio of total heat transfer to conductive heat transfer, where h is the convective heat transfer coefficient in $W/m^2K$, and k is the thermal conductivity of the fluid ($k_{water} = 0.6065 \, W/(m.K)$). A Nusselt number of 1 indicates conduction-dominated heat transfer. For fully developed laminar velocity profiles in non-circular pipes, the Nusselt number ranges less than ten.

$$Nu = \frac{Total\ heat\ transfer}{Fluid\ conduction\ heat\ transfer} = \frac{h \cdot D_H}{k} \qquad (7)$$

The convective heat transfer coefficient, h, was determined by dividing the input heat flux by the wall temperature difference, as shown in equation 8.

$$h = \frac{Q}{\Delta T_{wall}} \qquad (8)$$

This coefficient corresponds to the inverse slope of the fitted line in FIG 12 (c), where the heat flux is plotted against the wall temperature difference. The calculated Nusselt numbers are as follows:

Nu = 5.38 for a flow rate of 100µl/s,
Nu = 6.48 for a flow rate of 150µl/s, and
Nu = 6.77 for a flow rate of 200µl/s.

The Nusselt numbers obtained indicate that convective heat transfer through the fluid is more dominant than conductive heat transfer, emphasizing the benefits of microfluidic integration within the package. The obtained convective heat transfer coefficient and the Nusselt numbers are summarized in the table in FIG. 13.

Still further, FIG. 15 shows a comparison of a total thermal resistance $R_{total}$ for a reference PΓaFN package, a reference PΓaFN package on a heat sink, and microfluidic packages according to the present invention. The contribution of convective $R_{conv}$, conductive $R_{cond}$, and caloric $R_{caloric}$ thermal resistances is also shown for microfluidic packages. The graph is displayed in log-normal to highlight the differences.

As becomes apparent from the above, the presently disclosed measures demonstrates a simple, industry-compatible co-packaging approach of an electronic device and a fluid cooled lead frame 10 with a relatively high Nusselt number (Nu = 6.77), therewith providing for improves device power ratings, a reduced thermal resistance, and a controlled laminar flow with dominant convective heat transfer through conventional backend packaging processes.

In summary the present disclosure provides a novel approach to thermal management by integrating microfluidics directly into electronic package substrates. By incorporating serpentine microchannels within a lead frame, a cooling system is co-packaging with the electronic device and cooling systems.

Numerous variations may be contemplated by those skilled in the art. For example using different designs for the fluid channel design and/or exploring different materials and fabrication techniques. For instance, the three-layered assembly of the lead frame 10 of FIG. 4A, 4B may be replaced with a two-layered assembly as shown in FIG. 5C wherein each of the two layers 12, 14 is etched to a part of its depth in the pattern 11_1, 11_2 of the fluid channel, and the two layers are bonded to each other at their etched sides. Furthermore, fluid delivery in real-life applications could be implemented through PCBs or external systems similar to current automotive inverter module cooling technology. Also other cooling fluids, such as glycol may be contemplated.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

**Claims**

1. A packaged electronic device (1) comprising:

a lead frame (10) comprising a fluid channel (11);
an electronic device (20) mounted on a surface of the lead frame
a package (30) enclosing the lead frame and the electronic device comprising openings (12a, 12b) giving access to the fluid channel and terminals (40a, 40b) for providing electric contacts to the electronic device.

2. The packaged electronic device of claim 1, wherein the lead frame (10) is an assembly comprising a bottom plate (12), a central plate (13) and a top plate (14), wherein the central plate is patterned to form the fluid channel (11).

3. The packaged electronic device of claim 1 or 2, wherein the fluid channel (11) extends in a meandering manner through the lead frame (10).

4. The packaged electronic device of one of the preceding claims, wherein the lead frame has extension portions (15a, 15b) for coupling ends of the fluid channel (11) to the openings (12a, 12b).

5. The packaged electronic device of one of the preceding claims wherein the lead frame has further extension portions (16a, 16b) having at their free ends a respective opening (17a, 17b) through the lead frame distinct from the fluid channel.

6. The packaged electronic device of one of the preceding claims wherein the electronic device (20) is fixed to the surface of the lead frame with a metallic interconnect material.

7. The packaged electronic device of one of the preceding claims, wherein the lead frame (10) is connected with solder on a printed circuit board, PCB (70), comprised in the package (30).

8. The packaged electronic device according to claim 1, wherein the lead frame (10) comprises an assembly having a pair of plates (12, 14) having etched surfaces facing each other, wherein the plates are each etched to part of their depth in the pattern of the fluid channel.

9. A system comprising at least one packaged electronic device (1B) as claimed in any of the preceding claims and in addition comprising,

a power supply (51) for supplying an electric power to the electronic device;
a cooling fluid circuit (60) for circulating a cooling fluid through the fluid channel of the lead frame.

10. A method of packaging an electronic device (20) comprising:

providing a printed circuit board, PCB (70);
providing a lead frame (10) comprising a fluid channel (11);
fixing the lead frame (10) to the PCB (70);
fixing the electronic device (20) to a surface of the lead frame (10);
wirebonding the electric contacts of the electronic device (20) to electric terminal connections provided on the PCB (70);
encapsulating the PCB (70) provided with the lead frame (10) and the electronic device (20), therewith providing openings (12a, 12b) giving access to the fluid channel and providing terminals (40a, 40b) serving as electric contacts to the electronic device.

Fig. 1A

Fig. 1B

Fig. 2

Fig. 3

FIG. 4A

FIG. 4B

FIG. 5A

FIG. 5B

FIG. 5BA

FIG. 5BB

FIG. 5BC

FIG. 5BD

# FIG. 5C

Fig. 6

FIG. 7

RESISTANCE TEMPERATURE
DETECTORS (RTD)

22T

21T

HEATERS          HEATERS

3.2 mm

3.2 mm

0.4 mm

20T

FIG. 8

(a1) Type-A (Regular Substrate)          20T'

TTC - Sillicon

Ag-sinter
paste

Stencil

Bulk Cu Leadframe

BCS

(a2) Type-b (Regular Substrate)          20T

TTC - Sillicon

Stencil

μfluidic Cu Leadframe

10

FIG. 9

# FIG. 10

## Test Case - A

20T"
**Reference PQFN**
(without overmold)

70
BCS
TTC
Bulk Cu

## Test Case - B

20T'
**Reference PQFN
on heat sink**
(without overmold)

70
BCS
TTC
TIM
Bulk Cu
CHS    Water-cooled copper heat sink

Clamp

## Test Case - C

20T
**Microfluidic PQFN**
(without overmold)

70
10
TTC
µfluidic

FIG. 11

FIG. 12

FIG. 13

| | Test Case – A (Reference) | Test Case – B (Ref. on HS) | Test Case – C (Microfluidic package) | | |
|---|---|---|---|---|---|
| | | | 100ul/s | 150ul/s | 200ul/s |
| Max. $P_{in}$ [W] @$T_j$ = 300°C | 3.5 | 10 | 22 | 26 | 27.5 |
| $R_{total}$ [K/W] | 81.68 | 28.14 | 13.72 | 11.37 | 10.63 |
| $R_{caloric}$ [K/W] | - | - | 2.16 | 1.71 | 1.37 |
| $R_{conv}$ [K/W] | - | - | 11.22 | 9.32 | 8.92 |
| $R_{cond}$ [K/W] | - | - | 0.337 | 0.337 | 0.337 |
| Fluid velocity [m/s] | - | - | 0.67 | 1 | 1.33 |
| Reynolds number [-] | - | - | 250 | 375 | 500 |
| Convective Heat transfer coefficient [W/m$^2$K] | - | - | 8702 | 10474 | 10943 |
| Nusselt number [-] | - | - | 5.38 | 6.48 | 6.77 |

FIG. 14

FIG. 15

Europäisches
Patentamt

European
Patent Office

Office européen
des brevets

## EUROPEAN SEARCH REPORT

**Application Number**

EP 24 20 4472

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/128168 A1 (LEE CHIU-FENG [TW] ET AL) 18 April 2024 (2024-04-18) * paragraph [0016] * * figures 1-3 * * paragraph [0022] * * paragraph [0018] * | 1-5,7-10 | INV. H01L23/495 H01L23/473 H05K7/20 H05K1/02 H01L23/48 |
| X | CN 111 933 599 A (GREAT TEAM BACKEND FOUNDRY DONGGUAN LTD) 13 November 2020 (2020-11-13) * paragraph [0037] - paragraph [0038] * * paragraph [0040] * * figures 1-4 * | 1-3,5-10 | ADD. H01L23/31 |
| X | CN 111 987 001 A (GREAT TEAM BACKEND FOUNDRY DONGGUAN LTD) 24 November 2020 (2020-11-24) * paragraph [0059] * * figures 1-9 * | 1-3,5, 7-10 | |

**TECHNICAL FIELDS SEARCHED (IPC)**

H01L
H05K

The present search report has been drawn up for all claims

| Place of search | Date of completion of the search | Examiner |
|---|---|---|
| The Hague | 7 March 2025 | Rodríguez San S., H |

EPO FORM 1503 03.82 (P04C01)

## ANNEX TO THE EUROPEAN SEARCH REPORT
## ON EUROPEAN PATENT APPLICATION NO.

EP 24 20 4472

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2025

| Patent document cited in search report | Publication date | Patent family member(s) | Publication date |
|---|---|---|---|
| US 2024128168 A1 | 18-04-2024 | CN 117913049 A<br>US 2024128168 A1 | 19-04-2024<br>18-04-2024 |
| CN 111933599 A | 13-11-2020 | NONE | |
| CN 111987001 A | 24-11-2020 | NONE | |

EPO FORM P0459

For more details about this annex : see Official Journal of the European Patent Office, No. 12/82

# EP 4 723 171 A1

**Patent documents cited in the description**

- US 2009294954 A